# EUROPÄISCHE PATENTSCHRIFT

(11) **EP 1 568 978 B1**
(45) Veröffentlichungstag und Bekanntmachung des Hinweises auf die Patenterteilung: **04.06.2014**
(21) Anmeldenummer: 05101048.6
(22) Anmeldetag: 14.02.2005
(51) Int. Cl.: G01K 1/20

(54) **Temperatursensor**
Temperature sensor
Capteur de température

(30) Priorität: 24.02.2004 DE 102004008977
(43) Veröffentlichungstag der Anmeldung: 31.08.2005
(73) Patentinhaber: Siemens Aktiengesellschaft, 80333 München (DE)
(72) Erfinder: Jonas, Stephan, 92431, Neunburg (DE); Reichenbach, Norbert, 92224, Amberg (DE)

(56) Entgegenhaltungen:
- EP-A- 0 547 750
- EP-A- 1 369 915
- WO-A-01/90710
- DE-A1- 19 742 236
- DE-A1- 19 802 296
- US-A- 4 602 125

## Beschreibung

Die vorliegende Erfindung betrifft einen Temperatursensor, insbesondere für Halbleiterbauelemente.

In der Leistungselektronik ist eine genaue Temperaturmessung die Grundvoraussetzung für einen effektiven Schutz eines Halbleiterbauelements. Bei bekannten Temperatursensoren in konventioneller Bauweise treten bauartbedingt zum Teil erhebliche Messfehler auf, wenn sich die Temperatur an der Messstelle und die Umgebungstemperatur stark voneinander unterscheiden. Darüber hinaus kommt es bei diesen Temperatursensoren zu einer zum Teil erheblichen Beeinflussung der Messergebnisse durch die Kühlbedingungen, denen der Temperatursensor am Einbauort ausgesetzt ist.

Es sind Temperatursensoren bekannt, bei denen temperatursensitive Elemente in SMD-Bauweise zum Einsatz kommen. Die Verwendung eines SMD-Elements bietet gegenüber herkömmlichen Temperatursensoren Kosten- und Fertigungsvorteile. Jedoch treten auch hier zum Teil erhebliche Messfehler auf, insbesondere, wenn das Sensorelement einer erzwungenen Konvektion, beispielsweise verursacht durch einen Lüfter, ausgesetzt ist.

Aus der europäischen Patentanmeldung EP 0 547 750 A1 ist ein auf einer elektrisch isolierenden Trägerschicht angeordneter Temperatursensor bekannt, der mit einem thermisch isolierendem Gehäuse versehen werden kann. Alternativ dazu ist es beschrieben, den Temperatursensor mit Hilfe eines Kunststoffmaterials einzukapseln. Beide Maßnahmen führen u.a. dazu, dass sich die thermischen Auswirkungen der Anschlussleitungen auf den Temperatursensor verringern. Die Genauigkeit der Temperaturmessung kann dadurch bereits etwas erhöht werden, ist jedoch noch immer nicht zufriedenstellend.

DE 19802296 A1 zeigt einen Temperaturfühler zur Messung von Oberflächentemperaturen. Der sich in einem Gehäuse befindende Temperaturfühler weist hierbei ein Sensorelement und ein nach außen führendes Anschlußkabel auf. Durch diesen Temperaturfühler wird eine definierte Wärmeführung ermöglicht. Hierbei wird der in das Gehäuse eindringende Wärmestrom in mindestens zwei Teilströme aufgeteilt, wobei der Teilstrom zum Sensorelement über einen höheren Wärmewiderstand geleitet wird als der Teilstrom zum Anschlußkabel.

Aufgabe der vorliegenden Erfindung ist es, eine noch genauere, von den Umgebungsverhältnissen unabhängige Temperaturmessung zu ermöglichen. Diese Aufgabe wird durch einen Temperatursensor gemäß Anspruch 1 gelöst.

Ein Grundgedanke der Erfindung ist es, Messfehler durch einen neuartigen Aufbau des Temperatursensors zu minimieren. Auf einem elektrisch isolierenden Träger, der zur Ankopplung des Temperatursensors an ein Messobjekt, beispielsweise einen Kühlkörper eines Halbleiterbauelementes, dient, ist ein in Oberflächen-montierbarer Bauweise (SMD-Bauweise) ausgeführtes temperatursensitives Element angeordnet. Dies bietet nicht nur Kosten- und Fertigungsvorteile. Das temperatursensitive Element, beispielsweise ein Thermistor (temperaturabhängiger Widerstand), kann auch über seine elektrischen Kontaktflächen, die vorzugsweise aus einem sehr gut wärmeleitenden Material bestehen, thermisch gut an den Träger angekoppelt werden. Die Dicke des Trägers wird dabei entsprechend der geforderten elektrischen Isolationsfähigkeit und den Fertigungsanforderungen so dünn wie möglich gewählt. Hierdurch wird ein geringer thermischer Widerstand zwischen dem temperatursensitiven Element und dem Messobjekt, und damit eine gute thermische Kopplung erreicht. Je geringer der thermische Widerstand des Trägers dabei ist, desto geringer sind die Temperaturdifferenzen am isolierenden Träger, die durch parasitäre Wärmeströme verursacht werden. Durch eine zumindest das temperatursensitive Element thermisch und elektrisch isolierenden Abdeckung wird zudem die Entstehung parasitärer Wärmeströme vom temperatursensitiven Element hin zur Umgebung von Anfang an minimiert. Hierdurch können Temperaturdifferenzen am Träger und damit Messfehler des Temperatursensors deutlich reduziert werden. Die Abdeckung ist dabei derart ausgebildet, dass sie eine elektrische Isolation vorzugsweise aller auf dem Träger aufgebrachten elektrisch leitenden Teile bewirkt sowie eine thermische Isolation zumindest des temperaturensitiven Elements sicherstellt.

Die Abdeckung wird durch einen schlecht wärmeleitenden Verguss mit ausreichenden elektrischen Isolationseigenschaften gebildet, der von einem Deckel umschlossen wird. Der Verguss deckt zumindest das temperatursensitive Element, vorzugsweise jedoch sämtliche auf den Träger aufgebrachten elektrischen Bauteile ab, so dass eine ausreichende elektrische und thermische Isolation gegeben ist. Dadurch ist eine Beachtung von Luft- und Kriechstrecken nicht notwendig, was eine kleine Bauform ermöglicht. Zugleich übernimmt der Verguss die Funktion einer Zugentlastung für die Anschlussleitungen des temperatursensitiven Elements.

Der erfindungsgemäße Temperatursensor ist nicht nur kostengünstig herstellbar. Er weist auch vergleichsweise geringe Abmessungen auf, so dass auch ein Einsatz unter stark beengten Platzverhältnissen möglich ist. Der Temperatursensor kann auch bei Potentialunterschieden zwischen Messobjekt und Temperaturauswerteeinheit eingesetzt werden. Die Beeinflussung des Messergebnisses durch hohe Temperaturunterschiede, beispielsweise 120K, zwischen Messstelle und Umgebung ist minimal. Auch die Kühlbedingungen, denen der Temperatursensor am Einbauort ausgesetzt ist, haben nur geringen Einfluss auf das Meßergebnis. Der erfindungsgemäße Temperatursensor kann beispielsweise bei der Messung der Temperatur eines Kühlkörpers, auf dem ein Halbleiterbauelement angeordnet ist, zum Einsatz kommen. Bei Kenntnis des zeitlichen und thermischen Verhaltens des Halbleiterelements und des Kühlkörpers kann mit der gemessenen Kühlkörpertemperatur mit Hilfe einer Temperaturauswerteeinheit die Temperatur des Halbleiterbauelements bestimmt werden und mit einer Steuereinheit in geeignete Austeuersignale für das Halbleiterbauelement umgesetzt werden. Dadurch ist es beispielsweise möglich, das Halbleiterbauelement bei Überschreitung einer maximalen Halbleitertemperatur abzuschalten. Durch eine genaue Temperaturmessung gemäß der Erfindung kann die Halbleitertemperatur exakter bestimmt werden, wobei eine knappere Dimensionierung des Halbleiterbauelements ohne größere Sicherheitsspanne und damit eine Einsparung von Material- und/oder Herstellungskosten möglich ist.

Der Temperatursensor ist jedoch nicht auf den Einsatz mit Halbleiterbauelementen beschränkt. Er ist vielmehr universell einsetzbar.

Vorteilhafte Ausführungsformen der Erfindung sind in den Unteransprüchen angegeben.

Gemäß einer Ausführungsform der Erfindung umfasst bzw. umschließt der Deckel dabei nach Art einer Glocke vorzugsweise alle auf dem Träger aufgebrachten elektrisch leitenden Teile. Der Deckel ist vorzugsweise direkt mit dem Träger verbunden und bildet zusammen mit dem Träger eine Art Gehäuse. Der Deckel besteht vorzugsweise aus einem thermisch und elektrisch isolierenden Material, beispielsweise aus einem Kunststoffmaterial.

Eine besonders sichere Montage ist möglich, wenn der Deckel unter Verwendung von Klebstoff formschlüssig mit dem Träger verbunden ist. Um die Abmessungen des Trägers möglichst gering zu halten, muss die Klebenaht dabei ausreichend elektrisch isolieren, um einen Spannungsüberschlag zu vermeiden. Die Reaktionszeit des temperatursensitiven Elements ist bei dieser Ausführungsform vergleichsweise kurz, da kein Vergussmaterial erwärmt werden muss. Daher eignet sich diese Ausführungsform des Temperatursensors besonders für Anwendungen, bei denen es auf eine schnelle Erkennung von Temperaturschwankungen ankommt.

In einer weiteren Ausführungsform der Erfindung wird der Deckel unter Ausbildung einer Rast-, Schnapp oder Klemmverbindung auf den Träger aufgedrückt. Deckel und/oder Träger sind zu diesem Zweck entsprechend ausgebildet. Sie weisen bzw. entsprechende Rast-, Schnapp- oder Klemmelemente auf und/oder sind in ihren Abmessungen zur Bildung derartiger Verbindungen aufeinander abgestimmt. Damit ist eine besonders einfache und dennoch sichere Fixierung möglich.

Besonders vorteilhaft ist es in diesem Zusammenhang, wenn der Deckel im montierten Zustand eine Gießform für den Verguss bildet. Vorteilhafterweise weist der Deckel hierzu mindestens eine Öffnung auf, durch die das Vergussmaterial eingefüllt werden kann. Diese Ausführungsform ist besonders für die Verwendung von flüssigem Vergussmaterial geeignet. Deckel und Träger bilden dann eine Gießform, die den Verguss bis zum Aushärten fixiert.

Gemäß einer weiteren Ausführungsform der Erfindung sind die auf dem Träger aufgebrachten Anschlussflächen zur elektrischen Kontaktierung des temperatursensitiven Elements durch Anschlussleitungen räumlich getrennt von dem temperatursensitiven Element angeordnet. Dies dient zur Vermeidung parasitärer Wärmeströme vom temperatursensitiven Element hin zu den Anschlussleitungen.

Zu dem gleichen Zweck ist in einer weiteren Ausführungsform vorgesehen, dass die zur elektrischen Verbindung des temperatursensitiven Elements mit den Anschlussflächen ausgebildeten Leiterbahnen auf dem Träger einen möglichst geringen Querschnitt aufweisen.

Das temperatursensitive Element wird dabei vorzugsweise über unregelmäßig, insbesondere mäander- oder zickzackförmig verlaufende Leiterbahnen mit den Anschlussflächen für die Anschlussleitungen verbunden. Auch dies dient zur Minimierung von parasitären Wärmeströmen vom temperatursensitiven Element hin zu den Anschlussleitungen.

Das temperatursensitive Element weist Kontaktflächen zur Kontaktierung des Trägers auf. Diese besitzen entsprechend der Erfindung mindestens die doppelte Grundfläche des temperatursensitiven Elementes. Durch diese Maßnahme erfolgt eine Konzentrierung des Wärmestromes vom Messobjekt auf das temperatursensitive Element. Die thermische Kopplung zum Messobjekt wird verbessert, wodurch sich der Einfluss parasitärer Wärmeströme verringert.

In einer weiteren Ausführungsform der Erfindung besteht der Träger aus einem Leiterplattenmaterial. Hierbei wird vorzugsweise ein Leiterplattenmaterial mit einer Dicke von 0,5 bis 1,0 mm verwendet. Für eine gute thermische Kopplung des temperatursensitiven Elementes ist prinzipiell die Verwendung eines möglichst dünnen Trägers von Vorteil.

Besonders vorteilhaft ist es, wenn als Träger ein beidseitig kupferkaschiertes Leiterplattenmaterial mit einer Dicke von 0,5 bis 1,0 mm verwendet wird. Durch die Kupferkaschierung wird erreicht, dass im Fall eines nicht planen Aufliegens des Trägers auf dem Messobjekt im Bereich des temperatursensitiven Elementes auch Wärmeströme aus solchen Bereichen, die plan aufliegen, zum temperatursensitiven Element geleitet werden.

Anstelle eines herkömmlichen Leiterplattenmaterials wird in einer weiteren Ausführungsform der Erfindung als Trägermaterial eine elektrisch isolierende, wärmeleitende Keramik verwendet. Derartige Keramiken weisen, verglichen mit Leiterplattenmaterial, eine wesentlich höhere Wärmeleitfähigkeit auf. Parasitäre Wärmeströme spielen nur noch eine untergeordnete Rolle. Als besonders vorteilhaft haben sich hierbei Trägerdicken im Bereich von 0,4 bis 0,63 mm erwiesen. Zur Erhöhung der Handhabungs- und Montagesicherheit und zur Vermeidung von Beschädigungen des Trägers werden vorzugsweise hochfeste Keramiken verwendet.

Zur Befestigung des Trägers an dem Messobjekt sind in einer weiteren Ausführungsform der Erfindung geeignete Befestigungsmittel vorgesehen. Für das Erreichen möglichst geringer Abmessungen und ein sicheres, planes Aufliegen des Trägers auf dem Messobjekt haben sich Ein-Loch-Befestigungen als besonders geeignet herausgestellt. Hierzu weist der Träger eine vorzugsweise mittig angeordnete Befestigungsöffnung zur Ausbildung einer Schraub- bzw. Steckverbindung oder dergleichen auf. Es sind jedoch auch eine Vielzahl anderer Befestigungsmöglichkeiten denkbar. So kann der Temperatursensor beispielsweise auf das Messobjekt aufgeklebt werden.

Die vorliegende Erfindung wird nachfolgend anhand von Ausführungsbeispielen beschrieben, die mit Hilfe von Zeichnungen näher erläutert werden. Hierbei zeigen:
- FIG 1: eine Draufsicht auf einen Temperatursensor ohne Abdeckung,
- FIG 2: eine Draufsicht auf den Temperatursensor mit Abdeckung,
- FIG 3: einen Schnitt durch den Temperatursensor entlang der Linie AA in FIG 2,
- FIG 4: einen Schnitt durch einen weiteren Temperatursensor ohne Verguss, und
- FIG 5: einen Schnitt durch einen weiteren Temperatursensor ohne Deckel.

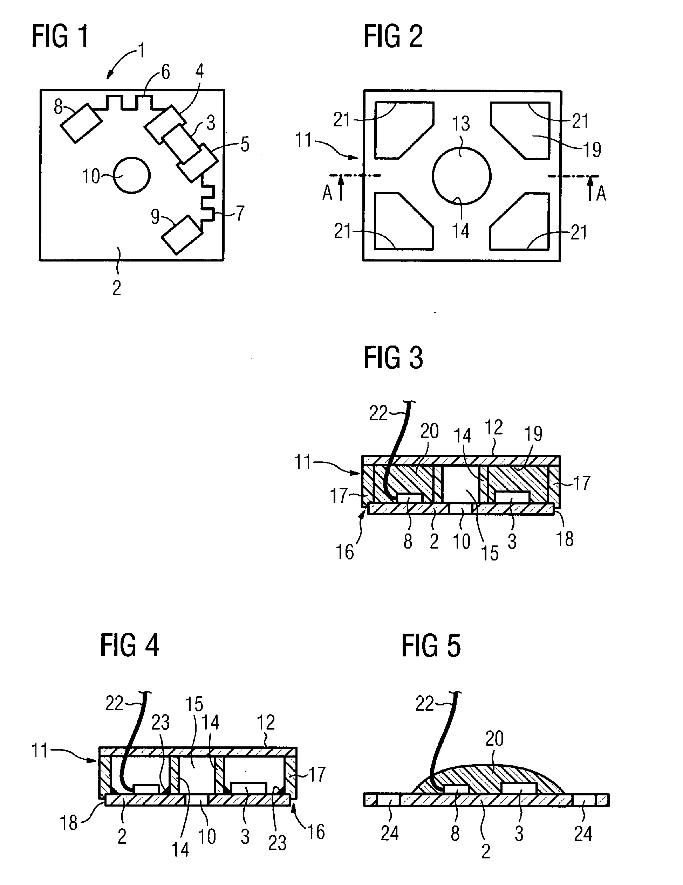

FIG 1 zeigt einen erfindungsgemäßen Temperatursensor 1 mit einem quadratischen Träger 2 und einem darauf angeordneten temperatursensitiven Element 3 in SMD-Bauweise.

Das temperatursensitive Element 3 weist zwei Kontaktflächen 4, 5 aus Kupfer auf, die mit dem Träger 2 durch eine Lötverbindung verbunden sind. Von dem temperatursensitiven Element 3 mit seinen beiden Kontaktflächen 4, 5 gehen zwei Leiterbahnen 6, 7 zu jeweils einer von dem temperatursensitiven Element 3 beabstandeten Anschlussfläche 8, 9, an die jeweils eine Anschlussleitung 22 (vgl. FIG 3) angelötet ist. Die Leiterbahnen 6, 7 weisen einen Querschnitt von 0,18 mm x 0,18 mm = 0,035 mm² auf und verlaufen mäanderförmig. Geringere Querschnitte sind prinzipiell möglich, sind jedoch mit höheren Herstellungskosten verbunden.

Das Trägermaterial ist Standard-Leiterplattenmaterial FR4 der Dicke 0,6 mm. Die Abmessungen des Trägers 2 betragen dabei 12 x 12 x 0,6 mm (L x B x H). Er ist beidseitig kupferkaschiert.

Die Isolationsfestigkeit des Trägers 2 ist ausreichend für Betriebsspannungen bis 1000 V AC. Der Träger 2 weist eine zentrisch angeordnete Bohrung 10 zur Befestigung an einem Kühlkörper eines Halbleiterelementes oder dergleichen (nicht abgebildet) auf.

Der Temperatursensor 1 ist in dieser Ausführungsform nach Art eines Gehäuses ausgebildet. Dieses setzt sich einerseits aus dem Träger 2 und andererseits aus einem Gehäusedeckel 11 aus Polyamid zusammen. Einen Temperatursensor 1 mit aufgesetztem Gehäusedeckel 11 zeigt FIG 2. Der Gehäusedeckel 11 deckt dabei die auf dem Träger 2 aufgebrachten Bauteile ab. Zur Ausbildung einer Ein-Loch-Schraubbefestigung weist der Gehäusedeckel 11 an seiner Oberseite 12 eine zu der Bohrung 10 im Träger 2 fluchtend angeordnete zentrische Öffnung 13 auf, die sich als durch eine Seitenwand 14 begrenzte Durchführung 15 zur Unterseite 16 des Gehäusedeckels 11 hin verlängert.

Zur Fixierung des Gehäusedeckels 11 wird dieser auf den Träger 2 aufgedrückt, vgl. FIG 3. Die Außenwände 17 des Gehäusedeckels 11 sind dabei mit den Begrenzungskanten 18 des Trägers 2 verbunden. Die Seitenwand 14 der Durchführung 15 liegt im montierten Zustand auf dem Träger 2 auf. Gehäusedeckel 11 und Träger 2 bilden mit anderen Worten ein Gehäuse mit einer um die Durchführung 15 herumführenden Kammer 19. Diese Kammer 19 bildet die Gussform für einen Verguss 20, welches nach der Montage des Gehäusedeckels 11 durch eine oder mehrere der an der Oberseite 12 des Gehäusedeckels 11 vorgesehenen vier weiteren Gehäuseöffnungen 21 eingefüllt wird. Als Vergussmaterial kann beispielsweise ein Zwei-Komponenten-Epoxidharz wie Araldit oder dergleichen zum Einsatz kommen.

Der Verguss 20 füllt die Kammer 19 zumindest teilweise aus derart, dass die auf dem Träger 2 aufgebrachten Bauteile überdeckt sind. Vorzugsweise wird die Kammer 19 jedoch vollständig mit dem Vergussmaterial ausgefüllt. Der Verguss 20 übernimmt sowohl die thermische Isolation des temperatursensitiven Elements 3 als auch die elektrische Isolation aller elektrisch leitenden Teile 4, 5, 6, 7, 8, 9 innerhalb der Kammer 19. Zusätzlich dient der Verguss 20 der Zugentlastung der an den Anschlussflächen 8, 9 angebrachten Anschlussleitungen 22, die den Temperatursensor 1 beispielsweise mit einer Temperaturauswerteeinheit (nicht abgebildet) verbinden. Die Anschlussleitungen 22 werden dabei durch zwei der Gehäuseöffnungen 20 nach außen geführt.

Bei natürlicher Konvektion und einer Umgebungstemperatur von T(a) = 22°C sowie einer Kühlkörpertemperatur T(heatsink) = 117°C wurde mit einem solchen Temperatursensor 1 eine Temperatur von T(sens) = 116°C gemessen. Dies entspricht einem relativen Fehler von etwa 1%. Wird der Temperatursensor 1 einer erzwungenen Konvektion ausgesetzt, indem der Luftstrom eines Lüfters direkt auf das temperatursensitive Element 3 gerichtet ist, bleibt der relative Fehler immer noch deutlich unter 3%. Im Vergleich zu herkömmlichen Lösungen, bei denen der relative Fehler bei natürlicher Konvektion zwischen 5% und 25% und bei erzwungener Konvektion zwischen 15% und 30% liegt, führt der Einsatz des erfindungsgemäßen Temperatursensors 1 somit zu einer erheblichen Minimierung des Messfehlers.

Bei der in FIG 4 gezeigten Ausführungsform die nicht der beanspruchten Erfindung entspricht, wird ein Gehäusedeckel 11 auf den Träger 2 aufgeklebt. Die Klebenähte 23 verlaufen dabei sowohl an den Außenwänden 17 des Gehäusedeckels 11 als auch an der Seitenwand 14 der Durchführung 15. Dabei ist die Klebung so ausgeführt, dass die elektrische Isolation zwischen einem unterhalb des Trägers 2 angeordneten Kühlkörper (nicht abgebildet) und den elektrisch leitenden Teilen 3, 4, 5, 6, 7, 8, 9 des Temperatursensors 1 in der Kammer 19 sichergestellt ist. Die von der Kammer 19 umschlossene Luft dient zur thermischen Isolation.

FIG 5 zeigt eine weitere Ausführungsform des Temperatursensors 1 ohne Ausbildung eines Gehäuses die nicht der beanspruchten Erfindung entspricht. Auf das temperatursensitive Element 3 und alle anderen, auf dem Träger angeordneten elektrisch leitenden Teile 4, 5, 6, 7, 8, 9 ist ein zäher Verguss 20 aufgebracht, der die elektrische und thermische Isolation übernimmt. Zur Befestigung am Kühlkörper dient hier eine Zwei-Loch-Befestigung. Zu diesem Zweck weist der Träger 2 aus Leiterplattenmaterial zwei seitlich angeordnete Bohrungen 24 auf.

## Patentansprüche

1. Temperatursensor (1)
- mit einem elektrisch isolierenden Träger (2),
- mit einem auf dem Träger (2) aufgebrachten temperatursensitiven Element (3) in SMD-Bauweise, und
- mit einer zumindest das temperatursensitive Element (3) thermisch und elektrisch isolierenden Abdeckung in Form eines Vergusses (20) aus thermisch und elektrisch isolierendem Material, der von einem Deckel (11) umschlossen ist,
wobei das temperatursensitive Element (3) wenigstens eine Kontaktfläche (4, 5) zum Träger (2) aufweist,
**dadurch gekennzeichnet , dass** die Kontaktfläche mindestens die doppelte Grundfläche des temperatursensitiven Elements (3) aufweist.

2. Temperatursensor (1) nach Anspruch 1,
**dadurch gekennzeichnet, dass** der Deckel (11) auf dem Träger (2) aufgebrachte, elektrisch leitende Teile umfasst.

3. Temperatursensor (1) nach Anspruch 2,
**dadurch gekennzeichnet, dass** der Deckel (11) aus einem thermisch und elektrisch isolierenden Material besteht.

4. Temperatursensor (1) nach Anspruch 2 oder 3,
**dadurch gekennzeichnet, dass** der Deckel (11) kraft- und/oder formschlüssig mit dem Träger (2) verbunden ist.

5. Temperatursensor (1) nach einem der Ansprüche 1 bis 4,
**dadurch gekennzeichnet, dass** der Deckel (11) im Montageendzustand eine Gießform für den Verguss (20) bildet.

6. Temperatursensor (1) nach einem der Ansprüche 1 bis 5,
**gekennzeichnet durch** mit dem temperatursensitiven Element (3) elektrisch verbundene, räumlich getrennt von dem temperatursensitiven Element (3) auf dem Träger (2) aufgebrachte Anschlussflächen (8, 9).

7. Temperatursensor (1) nach Anspruch 6,
**gekennzeichnet durch** Leiterbahnen (6, 7) geringen Querschnitts zur elektrischen Verbindung des temperatursensitiven Elements (3) mit den Anschlussflächen (8, 9).

8. Temperatursensor (1) nach Anspruch 6 oder 7,
**gekennzeichnet durch** mäander- oder zickzackförmig verlaufende Leiterbahnen (6, 7) zur elektrischen Verbindung des temperatursensitiven Elements (3) mit den Anschlussflächen (8, 9).

9. Temperatursensor (1) nach einem der Ansprüche 1 bis 8,
**dadurch gekennzeichnet, dass** der Träger (2) aus Leiterplattenmaterial besteht.

10. Temperatursensor (1) nach Anspruch 9,
**dadurch gekennzeichnet, dass** die Trägerdicke 0,5 bis 1,0 mm beträgt.

11. Temperatursensor (1) nach Anspruch 9 oder 10,
**dadurch gekennzeichnet, dass** das Leiterplattenmaterial beidseitig kupferkaschiert ist.

12. Temperatursensor (1) nach einem der Ansprüche 1 bis 8,
**dadurch gekennzeichnet, dass** der Träger (2) aus einer elektrisch isolierenden, wärmeleitenden Keramik besteht.

13. Temperatursensor (1) nach Anspruch 12,
**dadurch gekennzeichnet, dass** die Trägerdicke 0,40 bis 0,63 mm beträgt.

14. Temperatursensor (1) nach einem der Ansprüche 1 bis 13, **gekennzeichnet durch** wenigstens ein Befestigungselement (10, 13, 15, 24) zur Fixierung des Trägers (2) an einem Messobjekt.

15. Temperatursensor (1) nach Anspruch 14,
**dadurch gekennzeichnet, dass** der Träger (2) eine einzige Befestigungsöffnung (10) zur Ausbildung einer Ein-Loch-Befestigung aufweist.

## Claims

1. Temperature sensor (1)
- having an electrically insulating substrate (2),
- having a temperature-sensitive element (3) attached to the substrate (2) in SMD design, and
- having a covering thermally and electrically insulating at least the temperature-sensitive element (3) in the form of a casting (2) made of thermally and electrically insulating material, which is enclosed by a cover (11),
wherein the temperature-sensitive element (3) comprises at least one contact surface (4, 5) relative to the substrate (2), **characterised in that**
the contact surface has at least twice the base surface of the temperature-sensitive element (3).

2. Temperature sensor (1) according to claim 1,
**characterised in that**
the cover (11) includes electrically conducting parts attached to the substrate (2).

3. Temperature sensor (1) according to claim 2,
**characterised in that**
the cover (11) consists of a thermally and electrically insulating material.

4. Temperature sensor (1) according to claim 2 or 3,
**characterised in that**
the cover (11) is connected to the substrate (2) in a force- and/or form-fit manner.

5. Temperature sensor (1) according to one of claims 1 to 4,
**characterised in that**
the cover (11), in the final assembly state, forms a casting mould for the casting.

6. Temperature sensor (1) according to one of claims 1 to 5,
**characterised by**
connecting surfaces (8, 9) attached to the substrate (2), spatially separated from the temperature-sensitive element (3) and electrically connected to the temperature-sensitive element (3).

7. Temperature sensor (1) according to claim 6,
**characterised by**
conductor paths (6, 7) with a smaller cross-section for electrically connecting the temperature-sensitive element (3) to the connecting surfaces (8, 9).

8. Temperature sensor (1) according to claim 6 or 7,
**characterised by**
meandering or zigzag-shaped conductor paths (6, 7) for electrically connecting the temperature-sensitive element (3) to the connecting surfaces (8, 9).

9. Temperature sensor (1) according to one of claims 1 to 8,
**characterised in that**
the substrate (2) consists of printed circuit board material.

10. Temperature sensor (1) according to claim 9,
**characterised in that**
the substrate thickness amounts to 0.5 to 1.0 mm.

11. Temperature sensor (1) according to claim 9 or 10,
**characterised in that**
the printed circuit board material is copper-coated on both sides.

12. Temperature sensor (1) according to one of claims 1 to 8,
**characterised in that**
the substrate (2) consists of an electrically insulating, heat-conducting ceramic.

13. Temperature sensor (1) according to claim 12,
**characterised in that**
the substrate thickness amounts to 0.40 to 0.63 mm.

14. Temperature sensor (1) according to one of claims 1 to 13,
**characterised by**
at least one fastening element (10, 13, 15, 24) for fixing the substrate (2) to a device under test.

15. Temperature sensor (1) according to claim 14,
**characterised in that**
the substrate (2) has a single fastening opening (10) for embodying a one-hole fastening.

## Revendications

1. Capteur ( 1 ) de température
- comprenant un support ( 2 ) isolant du point de vue électrique,
- comprenant un élément ( 3 ) en mode de construction SMD sensible à la température, déposé sur le support ( 2 ), et
- comprenant un recouvrement sous la forme, d'un scellement ( 20 ) en un matériau isolant du point de vue thermique et du point de vue électrique qui isole, du point de vue thermique et du point de vue électrique, au moins l'élément ( 3 ) sensible à la température et qui est entouré d'un couvercle ( 11 ), dans lequel l'élément ( 3 ) sensible à la température à au moins une surface ( 4, 5 ) de contact avec le support ( 2 ),
**caractérisé en ce que**
la surface de contact a au moins le double de la surface de base de l'élément ( 3 ) sensible à la température.

2. Capteur ( 1 ) de température suivant la revendication 1, **caractérisé en ce que** le couvercle ( 11 ) comprend des parties conductrices de l'électricité, qui sont mises sur le support ( 2 ).

3. Capteur ( 1 ) de température suivant la revendication 2, **caractérisé en ce que** le couvercle ( 11 ) est en un matériau isolant du point de vue thermique et du point de vue électrique.

4. Capteur ( 1 ) de température suivant la revendication 2 ou 3,
**caractérisé en ce que** le couvercle ( 11 ) est relié au support ( 2 ) à complémentarité de force et/ou à complémentarité de forme.

5. Capteur ( 1 ) de température suivant l'une des revendications 1 à 4,
**caractérisé en ce que** le couvercle ( 11 ) forme, à l'état de montage, un moule de coulée pour le scellement ( 20 ).

6. Capteur ( 1 ) de température suivant l'une des revendications 1 à 5,
**caractérisé par** des surfaces ( 8, 9 ) de connexion reliées électriquement à l'élément ( 3 ) sensible à la température, séparées spatialement de l'élément ( 3 ) sensible à la température et déposées sur le support ( 2 ).

7. Capteur ( 1 ) de température suivant la revendication 6,
**caractérisé par** des pistes ( 6, 7 ) conductrices de section transversale petite pour la liaison électrique de l'élément ( 3 ) sensible à la température aux surfaces ( 8, 9 ) de connexion.

8. Capteur ( 1 ) de température suivant la revendication 6 ou 7,
**caractérisé par** des pistes ( 6, 7 ) conductrices sinueuses ou en zigzag pour la liaison électrique de l'élément ( 3 ) sensible à la température aux surfaces ( 8, 9 ) de connexion.

9. Capteur ( 1 ) de température suivant l'une des revendications 1 à 8,
**caractérisé en ce que** le support ( 2 ) est en un matériau de plaquette à semiconducteur.

10. Capteur ( 1 ) de température suivant la revendication 9,
**caractérisé en ce que** l'épaisseur du support va de 0,5 à 1,0 mm.

11. Capteur ( 1 ) de température suivant la revendication 9 ou 10,
**caractérisé en ce que** le matériau de plaquette à circuit imprimé est plaqué de cuivre sur les deux faces.

12. Capteur ( 1 ) de température suivant l'une des revendications 1 à 8,
**caractérisé en ce que** le support ( 2 ) est en une céramique isolante du point de vue électrique et conductrice de la chaleur.

13. Capteur ( 1 ) de température suivant la revendication 12,
**caractérisé en ce que** l'épaisseur du support va de 0,40 à 0,63 mm.

14. Capteur ( 1 ) de température suivant l'une des revendications 1 à 13,
**caractérisé par** au moins un élément ( 10, 13, 15, 24 ) de fixation pour l'immobilisation du support ( 2 ) sur un objet à mesurer.

15. Capteur ( 1 ) de température suivant la revendication 14,
**caractérisé en ce que** le support ( 2 ) a un trou ( 10 ) de fixation unique pour la formation d'une fixation par un seul trou.
